(19) Europäisches Patentamt
European Patent Office
Office européen des brevets

(11) **EP 4 667 630 A1**

(12) **EUROPEAN PATENT APPLICATION**
published in accordance with Art. 153(4) EPC

(43) Date of publication:
24.12.2025 Bulletin 2025/52

(21) Application number: 23922912.3

(22) Date of filing: 11.12.2023

(51) International Patent Classification (IPC):
D03D 15/267 (2021.01)     C08J 5/24 (2006.01)
D03D 1/00 (2006.01)       D06B 13/00 (2006.01)
D06M 13/507 (2006.01)     H05K 1/03 (2006.01)

(52) Cooperative Patent Classification (CPC):
C08J 5/24; D03D 1/00; D03D 15/267; D06B 13/00;
D06M 13/507; H05K 1/03

(86) International application number:
PCT/JP2023/044188

(87) International publication number:
WO 2024/171579 (22.08.2024 Gazette 2024/34)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 17.02.2023 JP 2023023729

(71) Applicant: Asahi Kasei Kabushiki Kaisha
Tokyo 1000006 (JP)

(72) Inventors:
• HASHIMOTO, Yuka
Tokyo 100-0006 (JP)
• HIROSE, Amane
Tokyo 100-0006 (JP)

(74) Representative: Hoffmann Eitle
Patent- und Rechtsanwälte PartmbB
Arabellastraße 30
81925 München (DE)

(54) **GLASS CLOTH, PREPREG, AND PRINTED WIRING BOARD**

(57) The present disclosure provides: a quartz glass fabric that comprises a glass yarn having a high silicon dioxide ($SiO_2$) content and is less fuzzy; and a prepreg, a printed wiring board, and others, each containing the quartz glass cloth. The glass cloth according to the present disclosure is configured using, as warps and wefts, glass yarns each comprising a plurality of filaments, in which the silicon (Si) content in the glass yarns is 95.0 wt% to 100 wt% inclusive in terms of silicon dioxide ($SiO_2$) content. The glass cloth has a thickness (T) of 80 $\mu$m or less, and satisfies the formula: /{(number of stacking warp yarn filaments in a bundle (N))-0.2/}/(thickness (T) [$\mu$m]) < 0.056.

Fig. 1

EP 4 667 630 A1

## Description

FIELD

The present disclosure relates to a glass fabric, a prepreg, a printed circuit board, and the like. The present international application claims the priority based on Japanese Patent Application No. 2023-023729 filed on February 17, 2023, and the entire content of the Japanese Patent Application is incorporated in the present international application.

BACKGROUND

Currently, information terminals such as smartphones are increasingly higher in performance, and communication typified by 5G communication is increasingly higher in speed. In view of such circumstances, in particular, printed circuit boards for high-speed communication are desired to achieve not only an increase in density, thinning, and an enhancement in heat resistance which have been conventionally required, but also further enhancements in dielectric characteristics (for example, lowered dielectric tangent) of insulation materials thereof. Similarly, prepregs used in insulation materials for printed circuit boards, glass fabrics included in the prepregs, and glass yarns constituting the glass fabrics are also desired to achieve enhancements in dielectric characteristics.

There are known procedures for constituting prepregs with low-dielectric glass in order to enhance dielectric characteristics of prepregs. In PTLs 1 and 2, a glass yarn having a compositional amount of silicon dioxide ($SiO_2$) of 98 to 100 wt% is used. PTL 3 describes a binding agent which inhibits fuzz of such a glass yarn from occurring.

In this regard, filament-opening treatments of glass fabrics can be performed to hardly cause bubbles called voids present in prepregs and printed circuit boards, and to enhance resin impregnation properties. Voids can be decreased and resin impregnation properties can be enhanced, thereby enhancing heat resistance and insulation properties of printed circuit boards, and it is thus known that filament-opening treatment processes are important for glass fabric production processes. PTLs 4 and 5 describe a filament-opening technique of a glass fabric by the pressure of water flow from waterjet or the like, and a filament-opening technique of a glass fabric by ultrasound or the like.

PTL 6 describes not only a decrease of voids, but also suppression of fuzz, which can be achieved with the variation in yarn width being within a specified range. PTL 7 describes enhancements in smoothness and resin impregnation properties of a glass fabric with a woven structure.

Glass fabrics are prescribed by various standards including the IPC standard which prescribes the warp and weft weaving densities, the filament diameter, and the number of filaments, and are usually woven according to such a standard. In general, use of yarns with small filament diameters can more easily reduce the thicknesses of glass fabrics and also can allow sufficient weaving densities to be ensured and hardly cause the problems of slippage and the like, and therefore it is known that small-thickness glass fabrics are woven with yarns with small filament diameters.

[CITATION LIST]

[PATENT LITERATURE]

[PTL 1] Japanese Unexamined Patent Publication (Kokai) No. 2018-127747
[PTL 2] Japanese Unexamined Patent Publication (Kokai) No. 2018-127752
[PTL 3] Japanese Unexamined Patent Publication (Kokai) No. 2015-78079
[PTL 4] Japanese Unexamined Patent Publication (Kokai) No. 2009-263824
[PTL 5] Japanese Unexamined Patent Publication (Kokai) No. 2020-158945
[PTL 6] Japanese Unexamined Patent Publication (Kokai) No. 2022-181738
[PTL 7] Japanese Unexamined Patent Publication (Kokai) No. 2003-82562

SUMMARY

[TECHNICAL PROBLEM]

The present inventors have made studies, and as a result, have found that use of quartz glass having a high silicon dioxide ($SiO_2$) content in the conventional techniques described in PTLs 1 to 7 has room for further improvement in terms of fuzz. The detail is described below.

An object of the present disclosure is to provide a quartz glass fabric which is constituted from a glass yarn having a silicon dioxide ($SiO_2$) content and which has less fuzz, and a prepreg, a printed circuit board and the like each comprising the quartz glass fabric.

[SOLUTION TO PROBLEM]

Some of aspects of the present disclosure are exemplified in the following Items [1] to [16].

[1] A glass fabric constituted from a warp yarn and a weft yarn, which are a glass yarn including a plurality of filaments, wherein

the glass yarn has a silicon (Si) content of from 95.0 wt% to 100 wt% in terms of silicon dioxide ($SiO_2$),
the glass fabric has a thickness (T) of 80 $\mu$m or less, and
the following formula (A1) is satisfied:

$$\{\text{Number of stacking warp yarn filaments in a bundle (N)} - 0.2\}/\text{thickness (T) } [\mu m] < 0.056 \ldots$$
$$\text{(A1)}$$

in the formula (A1), the number of stacking warp yarn filaments in a bundle (N) is a value determined by Warp yarn filament diameter [$\mu$m] × Number of warp yarn filaments [filaments]/Warp yarn width [$\mu$m].

[2] The glass fabric according to Item 1, wherein, when a cross section of the glass fabric is observed after the glass fabric is embedded in an epoxy resin and the epoxy resin is cured, the proportion of warp yarn adhesion calculated by the following formula is more than 0 and 0.80 or less:

Proportion of warp yarn adhesion = Number of adhesion points of filaments adhering to each other in warp yarn/ Number of warp yarn filaments.

[3] The glass fabric according to Item 1 or 2, wherein the glass fabric is treated with a surface treatment agent containing a silane coupling agent.
[4] The glass fabric according to Item 3, wherein the silane coupling agent contains a compound represented by the following formula (C):

$$X(R)_{3-n}SiY_n \ldots \qquad \text{(C)}$$

in the formula (C), X is an organic group having at least one of an amino group and an unsaturated double bond group having radical reactivity, Y is each independently an alkoxy group, n is an integer of 1 or more and 3 or less, and R is each independently a group consisting of a methyl group, an ethyl group, and a phenyl group.
[5] The glass fabric according to Item 4, wherein X in the formula (C) is an organic group having one or more methacryloyloxy groups or acryloyloxy groups.
[6] The glass fabric according to any one of Items 1 to 5, wherein the glass yarn has an average filament diameter (D) of 4 $\mu$m or more.
[7] The glass fabric according to any one of Items 1 to 6, wherein the following formula (B1) is satisfied when the thickness of the glass fabric is 20 $\mu$m or more and 80 $\mu$m or less, and the following formula (B6) is satisfied when the thickness of the glass fabric is less than 20 $\mu$m.

$$24 \times \text{average filament diameter (D) } [\mu m] - \text{thickness (T) } [\mu m] > 96 \ldots \text{(B1)}$$

$$14 \times \text{average filament diameter (D) } [\mu m] - \text{thickness (T) } [\mu m] > 46 \ldots \text{(B6)}$$

[8] The glass fabric according to any one of Items 1 to 7, wherein the thickness (T) of the glass fabric is 60 $\mu$m or less.
[9] The glass fabric according to any one of Items 1 to 8, wherein the glass fabric has a value of loss of ignition in a range of 0.01 wt% to 0.30 wt%.
[10] The glass fabric according to any one of Items 1 to 9, for a printed circuit board.
[11] A prepreg containing the glass fabric according to any one of Items 1 to 10, a thermosetting resin, and an inorganic filler.
[12] A printed circuit board comprising the prepreg according to Item 11.

[13] An integrated circuit comprising the printed circuit board according to Item 12.

[14] An electronic device comprising the printed circuit board according to Item 12.

[15] A method for producing a glass fabric, the method comprising:

weaving a glass yarn, which includes a plurality of filaments and has a Si content in a range of 95.0 wt% to 100 wt% in terms of $SiO_2$, as each of a warp yarn and a weft yarn, to obtain a glass fabric; and

wherein the method further comprises a warping process of flattening and then sizing a yarn bundle of the glass yarn before the weaving process; and

wherein the method further comprises, after the warping process and before, during or after the weaving process, the following:

washing the glass yarn with water at 50°C or more;

heating/de-oiling the glass yarn washed; and

washing and filament-opening the heated/de-oiled glass yarn, with conveying the glass yarn at a rate of 50 m/min or less in a liquid being irradiated with ultrasound;

wherein the glass fabric after the filament-opening treatment has a thickness (T) of 80 μm or less, and the following formula (B 1) is satisfied when the thickness of the glass fabric after the filament-opening treatment is 20 μm or more and 80 μm or less, and the following formula (B6) is satisfied when the thickness of the glass fabric after the filament-opening treatment is less than 20 μm.

$$24 \times \text{average filament diameter (D) [μm] - thickness (T) [μm]} > 96 \dots \text{(B1)}$$

$$14 \times \text{average filament diameter (D) [μm] - thickness (T) [μm]} > 46 \dots \text{(B6)}$$

[16] The method according to Item 15, further comprising subjecting the washed and filament-opened glass fabric to a surface treatment with a surface treatment agent.

[ADVANTAGEOUS EFFECTS OF INVENTION]

The present disclosure can provide a quartz glass fabric which is constituted from a glass yarn having a silicon dioxide ($SiO_2$) content and which has less fuzz, and a prepreg, a printed circuit board and the like each comprising the quartz glass fabric.

BRIEF DESCRIPTION OF DRAWING

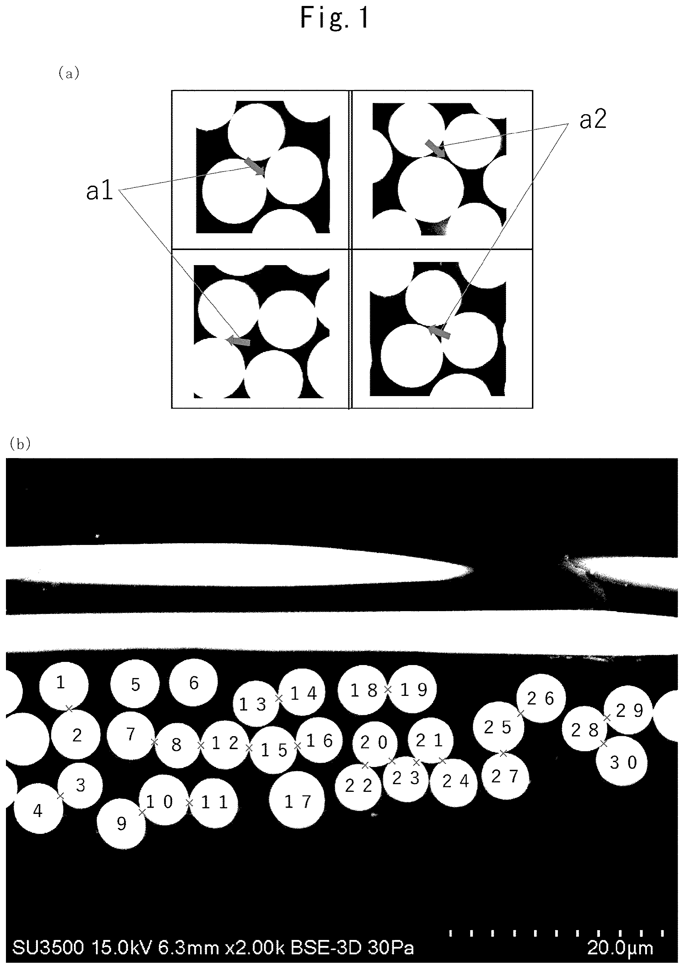

FIGS. 1(a) and (b) are SEM images for describing a procedure for calculating "proportion of adhesion" in the present disclosure.

DESCRIPTION OF EMBODIMENTS

Hereinafter, embodiments of the present disclosure are described, but the present disclosure is not limited thereto and can be variously modified without departing from the gist thereof.

In the present disclosure, a numerical value range described with "to" represents a numerical value range including numerical values before and after "to" respectively as the lower limit value and the upper limit value. The upper limit value or the lower limit value described with a certain numerical value range as a numerical value range described stepwise can be replaced with the upper limit value or the lower limit value of any other numerical value range described stepwise. Furthermore, the upper limit value or the lower limit value described with a certain numerical value range can also be replaced with any value shown in Examples. The term "process" includes not only an independent process, but also any process not clearly distinguishable from other processes as long as such any process can achieve the function of the relevant process.

<<Glass Fabric>>

The glass fabric of the present disclosure is a glass fabric which includes a glass yarn including a plurality of filaments, as each of a warp yarn and a weft yarn. The silicon (Si) content in the glass yarn is 95.0 wt% or more and 100 wt% or less in terms of silicon dioxide ($SiO_2$), the thickness (T) of the glass fabric is 80 μm or less, and the following formula (A1)

is satisfied:

$$\{\text{Number of stacking warp yarn filaments in a bundle (N)} - 0.2\}/\text{T}[\mu m] < 0.056 \dots \text{(A1)}$$

In the formula (A1), the "number of stacking warp yarn filaments in a bundle (N)" means the number of filament sections included in a warp yarn bundle in the glass fabric, as calculated from the warp yarn filament diameter $[\mu m]$, the number of warp yarn filaments [filaments] and the warp yarn width $[\mu m]$. In a preferred embodiment of the glass fabric of the present disclosure, when a cross section of the glass fabric is observed after the glass fabric is embedded in an epoxy resin and the resin is cured, the proportion of warp yarn adhesion calculated by the following formula:

Proportion of warp yarn adhesion = Number of adhesion points of filaments adhering to each other in warp yarn/Number of warp yarn filaments is more than 0 and 0.80 or less. A subject to be embedded in the epoxy resin may be at least one portion of the glass fabric.

As described in PTLs 1 and 2, in general, glass high in compositional amount of $SiO_2$ is low in bending resistance and is poor in flexibility even in the state of a glass fabric, and therefore is problematic because fuzz and/or wrinkles is/are easily caused as compared with other glass types. In this regard, PTL 1 describes a method for suppressing fuzz in a prepreg by surface-treating a glass fabric. PTL 2 describes a method for suppressing fuzz in a glass fabric with a glass yarn to which a predetermined amount of a gluing agent is attached. However, the present inventors have made studies, and as a result, have found that the method of PTL 1 cannot suppress fuzz occurring before the surface treatment and has room for improvement. It has also been found that the methods described in PTLs 1 and 2 have room for improvement particularly in terms of resin impregnation properties of the glass fabric.

PTL 3 describes a method for suppressing the occurrence of fuzz with a glass fiber binding agent having a specified composition. However, the present inventors have made studies, and as a result, have found that the method of PTL 3 suppresses fuzz optionally with no heating/de-oiling or filament-opening carried out, and therefore has room for improvement from the viewpoint of resin impregnation properties of the glass fabric.

PTL 6 describes a yarn having a small filament diameter, in which the yarn is inferior in mechanical strength as compared with a thick yarn, easily causes the occurrence of fuzz or the like, and is needed to be subjected to a filament-opening treatment under relatively mild conditions. PTL 6 also describes the occurrence of fuzz and voids in a portion varied in yarn width (variation portion), and describes control of the number of twists in a glass yarn, a binding agent, the tension in a weaving process, and the like, in which the control reduces the variation in yarn width and can reduce fuzz and voids. However, PTL 6 merely shows the effect with a glass fabric having a thickness of 20 $\mu m$ or less, and the present inventors have made studies, and as a result, have found that a glass fabric having a thickness of more than 20 $\mu m$ has room for improvement in terms of fuzz and voids (resin impregnation properties). PTL 6 merely lists, as the types of glass, E glass, T glass, S glass, UT glass, D glass, NE glass, L glass, and the like, the present inventors have made studies, and as a result, have found that quartz glass having lower dielectric characteristics has room for improvement in terms of fuzz and voids (resin impregnation properties).

PTLs 4 and 5 describe a filament-opening technique of a glass fabric by the pressure of water flow from waterjet or the like, and a filament-opening technique of a glass fabric by ultrasound or the like. A glass fabric can be subjected to a filament-opening treatment and thus reduced in voids and enhanced in resin impregnation properties. However, the present inventors have made studies, and as a result, have revealed that a glass fabric in which the compositional amount of $SiO_2$ in glass constituting a glass yarn is high is more inferior in mechanical strength as compared with other type of glass and therefore even a glass fabric having a relatively larger thickness of 80 $\mu m$ or less than the thickness of a glass fabric heretofore studied and applied in mild filament-opening conditions easily causes the occurrence of fuzz in conventional filament-opening treatments as described in PTLs 4 and 5. It has also revealed that quartz glass is high in hardness and is hardly filament-opened in mild filament-opening conditions and therefore fuzz and voids occur not only in a portion varied in yarn width, but also a portion where such a variation is less caused.

As a method other than physical processing, PTL 7 describes a method for enhancing resin impregnation properties by using a yarn having a large filament diameter and reducing the thread count, to reduce the confounding point and smoothen the surface. However, the present inventors have made studies, and as a result, there is room for improvement in terms of fuzz and resin impregnation properties.

On the contrary, the present disclosure can provide a glass fabric which is suppressed in occurrence of fuzz even with a glass yarn having a high silicon dioxide ($SiO_2$) content, and a prepreg, a printed circuit board and the like each comprising the glass fabric. The glass fabric of the present disclosure has a high silicon dioxide ($SiO_2$) content, and therefore can enhance dielectric characteristics (for example, reduce the dielectric tangents) of a prepreg and a printed circuit board. In a preferred embodiment, the glass fabric of the present disclosure has excellent resin impregnation properties, and therefore can enhance heat resistance of a prepreg and a printed circuit board being each a composite with a matrix resin.

Without limitation on the theory, the present inventors have made intensive studies about suppression of fuzz in the glass fabric in the case of use of quartz glass as the glass yarn, and as a result, have focused on the number of filament sections included in a warp yarn bundle (number of stacking warp yarn filaments in a bundle) because a warp yarn is more hardly filament-opened than a weft yarn. It has been then found that the number of filament sections can be controlled in a predetermined range to suppress the occurrence of fuzz. As described below in detail, when the number of stacking warp yarn filaments in a bundle is small relative to the thickness, the occurrence of fuzz can be suppressed. The inventors have further made intensive studies about suppression of fuzz in the glass fabric and improvements in resin impregnation properties in the case of use of quartz glass as the glass yarn, and as a result, have focused on the proportion of adhesion between filaments in a warp yarn bundle because a warp yarn is more hardly filament-opened than a weft yarn. The inventors have then found that the number of filament sections included in a warp yarn bundle (number of stacking warp yarn filaments in a bundle) and the proportion of adhesion between filaments can be controlled in predetermined ranges to not only suppress the occurrence of fuzz, but also enhance resin impregnation properties. When the proportion of warp yarn adhesion is low, resin impregnation properties can be enhanced. Such enhancements in resin impregnation properties lead to an enhancement in heat resistance of a prepreg and a printed circuit board.

Without limitations on any particular production method, in order to control the number of stacking warp yarn filaments in a bundle in a predetermined range, for example, it is preferable to use a yarn having a large filament diameter relative to the thickness of the glass fabric, to reduce the number of filaments, to flatten a yarn bundle during warping and then perform sizing processing (gluing), and to wash the glass fabric with water at a predetermined temperature or more before heating/de-oiling of the glass fabric. Without limitations on any particular production method, in order to control the number of stacking warp yarn filaments in a bundle and the proportion of warp yarn adhesion in predetermined ranges, for example, it is preferable to perform washing and a filament-opening treatment of a combustion residue of a sizing agent with ultrasound before a surface treatment of the glass fabric, and to control the conveying speed of the glass fabric to a predetermined speed or less, in addition to the above methods.

[Glass Yarn]

The glass yarn constituting the glass fabric can be obtained with, as a raw material, glass in which the Si content is in a range of 95.0 wt% to 100 wt% in terms of $SiO_2$. Use of such a glass yarn can allow for enhancements in dielectric characteristics of the resulting glass fabric. The Si content is preferably in the range of 98.0 wt% to 100 wt%, more preferably 99.0 wt% to 100 wt%, further preferably 99.5 wt% to 100 wt%, particularly preferably 99.9 wt% to 100 wt% in terms of $SiO_2$.

The average filament diameter of glass filaments constituting the glass yarn (also simply referred to as "filament diameter".) is preferably 4.0 $\mu$m or more and 11.0 $\mu$m or less. The lower limit value of the filament diameter is more preferably 4.5 $\mu$m or more, further preferably 5 $\mu$m or more, particularly preferably 5.5 $\mu$m or more. The upper limit value of the filament diameter, which can be combined with such a lower limit value, is more preferably 10.0 $\mu$m or less, further preferably 9.5 $\mu$m or less. In order to satisfy the formula (A1), the filament diameter, while depending on the number of filaments, is preferably 5.0 $\mu$m or more, more preferably 5.5 $\mu$m or more, particularly preferably 6.0 $\mu$m or more. When the filament diameter is equal to or more than the lower limit value, rupture strength of the filaments is increased and therefore fuzz hardly occurs in the resulting glass fabric. When the filament diameter is equal to or less than the upper limit value, the glass fabric is decreased in weight and therefore is easily conveyed or processed. When the filament diameter is in the above range, the effects of suppression of fuzz and enhancement of resin impregnation properties are easily obtained. In the present disclosure, when the "average filament diameter" (or "filament diameter") is simply described, this means the average filament diameter ($D_{MD}$) of only filaments constituting a warp yarn or the average filament diameter ($D_{TD}$) of only filaments constituting a weft yarn, and does not mean the average filament diameter (D) with respect to both the warp yarn and the weft yarn combined.

The average filament diameter (D) is a value calculated from the average filament diameter ($D_{MD}$) of the warp yarn and the average filament diameter ($D_{TD}$) of the weft yarn according to the following formula.

$$D = (D_{MD} + D_{TD})/2$$

The average filament diameter (D) is preferably 4.0 $\mu$m or more and 11.0 $\mu$m or less. The lower limit value of the average filament diameter (D) is preferably 4.0 $\mu$m or more, more preferably 4.5 $\mu$m or more, further preferably 5 $\mu$m or more, particularly preferably 5.5 $\mu$m or more. The upper limit value of the filament diameter (D), which can be combined with such a lower limit value, is more preferably 10.0 $\mu$m or less, further preferably 9.5 $\mu$m or less. In order to satisfy the formula (A1), the filament diameter (D), while depending on the number of filaments, is preferably 5.0 $\mu$m or more, more preferably 5.5 $\mu$m or more, particularly preferably 6.0 $\mu$m or more. When the filament diameter (D) is equal to or more than the lower limit value, rupture strength of the filaments is increased and therefore fuzz hardly occurs in the resulting glass fabric. When the filament diameter (D) is equal to or less than the upper limit value, the glass fabric is decreased in weight and therefore is easily conveyed or processed. When the filament diameter (D) is in the above range, the effects of suppression of fuzz and enhancement of resin impregnation properties are easily obtained.

The average number of filaments as glass filaments constituting the glass yarn (also simply referred to as "number of filaments".) is preferably 10 to 250, more preferably 15 to 200, further preferably 18 to 150, particularly preferably 20 to 120. When the number of filaments is 10 or more, yarn breakage tends to be suppressed. When the average number of filaments as glass filaments is in the above range, the effects of suppression of fuzz and enhancement of resin impregnation properties are easily obtained. In particular, in order to satisfy the formula (A1), the number of filaments in the glass yarn used in the warp yarn, while depending on the filament diameter, is preferably 150 or less, more preferably 120 or less, particularly preferably 100 or less. In the present disclosure, the average number of filaments is the average value of only filaments in the glass yarn constituting the warp yarn or the average value of only filaments in the glass yarn constituting the weft yarn, and is not the average value with respect to both the warp yarn and the weft yarn combined.

[Woven Structure and the like]

The glass fabric is constituted with a glass yarn including a plurality of glass filaments, as each of the warp yarn and the weft yarn. Examples of the woven structure of the glass fabric include woven structures such as plain-woven, basket-woven, sateen-woven, and twilled structures. In particular, a plain-woven structure is preferred.

The beating densities (weaving densities) of the warp yarn and the weft yarn constituting the glass fabric are each preferably 10 yarns/inch to 120 yarns/inch (= 10 to 120/25.4 mm), more preferably 40 yarns/inch to 120 yarns/inch. When the beating densities are in the above ranges, the effects of suppression of fuzz and enhancement of resin impregnation properties are easily obtained.

The basis weight of the glass fabric (the weight of the glass fabric) is preferably 8 g/m$^2$ to 90 g/m$^2$, more preferably 8 g/m$^2$ to 80 g/m$^2$, further preferably 8 g/m$^2$ to 70 g/m$^2$, particularly preferably 8 g/m$^2$ to 60 g/m$^2$. When the basis weight of the glass fabric is in the above range, the effects of suppression of fuzz and enhancement of resin impregnation properties are easily obtained.

The thickness (T) of the glass fabric is more than 0 μm and 80 μm or less. The upper limit value of the thickness (T) is preferably 60 μm or less, more preferably 55 μm or less, further preferably 50 μm or less. When the thickness of the glass fabric is in the above range, the effects of suppression of fuzz and enhancement of resin impregnation properties are easily obtained. The lower limit value of the thickness (T) of the glass fabric, which can be combined with such an upper limit value, may be preferably 5 μm or more, 10 μm or more, 15 μm or more, or 20 μm or more.

[Number of Stacking Warp Yarn Filaments in a Bundle]

The thickness (T) and the number of stacking warp yarn filaments in a bundle (N) of the glass fabric satisfy the following formula (A1). When the thickness and the number of stacking warp yarn filaments in a bundle of the glass fabric satisfy a relationship of the following formula (A1), a portion in which filaments are overlapped in a layered manner in the warp yarn is decreased relative to the thickness and unevenness in a glass fabric surface and a yarn bundle is homogenized to allow for suppression of fuzz. A portion in which filaments are overlapped in a layered manner in the warp yarn to form void spaces is also decreased relative to the thickness to allow for enhancements in resin impregnation properties.

$$\{\text{Number of stacking warp yarn filaments in a bundle (N) - 0.2}\}/\text{T[μm]} < 0.056 \ldots \text{(A1)}$$

In the glass fabric, the warp yarn, to which tension is applied during conveyance, is hardly filament-opened, and easily causes the occurrence of unevenness and void spaces in a yarn bundle as compared with the weft yarn, resulting in a tendency to easily cause the occurrence of fuzz and voids. Therefore, adjustment of the number of stacking warp yarn filaments in a bundle is effective for suppression of fuzz and enhancements in resin impregnation properties.

The number of stacking warp yarn filaments in a bundle (N) is a value calculated from the warp yarn width [μm] and the warp yarn filament diameter ($D_{MD}$) [μm], and the number of warp yarn filaments [filaments], according to the following formula.

Number of stacking warp yarn filaments in a bundle (N) = Warp yarn filament diameter ($D_{MD}$) [μm] × Number of warp yarn filaments [filaments]/Warp yarn width [μm]

The formula (A1) is more easily satisfied by preferably setting the filament diameter to a large value and setting the number of filaments to a small value, performing a flattening treatment of a yarn bundle before gluing in warping, and washing a sizing agent with water at 50°C or more before a heating/de-oiling treatment of the glass fabric.

The relationship between the thickness (T) and the number of stacking warp yarn filaments in a bundle (N) of the glass fabric ($\mu$m) preferably satisfy formula (A2), more preferably formula (A3), further preferably formula (A4), particularly preferably formula (A5).

$$\{N - 0.2\}/T[\mu m] < 0.054 \ ... \ (A2)$$

$$\{N - 0.2\}/T[\mu m] < 0.052 \ ... \ (A3)$$

$$\{N - 0.2\}/T[\mu m] < 0.050 \ ... \ (A4)$$

$$\{N - 0.2\}/T[\mu m] < 0.048 \ ... \ (A5)$$

[Proportion of Warp Yarn Adhesion]

The proportion of warp yarn adhesion is a value calculated from the number of filaments in the warp yarn and the number of adhesion points between filaments adhering to each other according to the following formula.

Proportion of warp yarn adhesion = Number of adhesion points of filaments adhering to each other in warp yarn/Number of warp yarn filaments

The number of adhesion points is measured by embedding the glass fabric in an epoxy resin to cure the epoxy resin and then observing a cross section of the glass fabric, as described in detail in the section of Examples. The proportion of warp yarn adhesion in the glass fabric of the present disclosure, as calculated according to the above formula, is preferably more than 0 and 0.80 or less. The proportion of warp yarn adhesion is more preferably more than 0 and 0.70 or less, further preferably more than 0 and 0.60 or less.

The glass fabric, having a lower proportion of warp yarn adhesion than a predetermined value, can obtain favorable resin impregnation properties because impregnation of a plurality of filaments with a resin is hardly inhibited. In order to provide control so that the proportion of warp yarn adhesion and the formula (A1) are simultaneously satisfied, not only, as described above, the filament diameter and the number of filaments are adjusted, the yarn bundle is subjected to a flattening treatment, and the sizing agent is washed, but also, for example, the combustion residue of the sizing agent is washed with ultrasound and a filament-opening treatment is performed before a surface treatment of the glass fabric, and the conveying speed of the glass fabric is controlled to a predetermined speed or less, to control the number of adhesion points between filaments.

The "filaments adhering to each other" in the above formula encompasses all of a case where a certain glass filament and another glass filament are contacted; a case where a surface-treated layer in a certain glass filament and another glass filament are contacted; and a case where a surface-treated layer in a certain glass filament and a surface-treated layer in another glass filament are contacted.

The "epoxy resin" in measurement of the proportion of warp yarn adhesion is a resin which allows for calculation of the proportion of adhesion according to the gist of the present disclosure, and more specifically a resin described in Examples is used. When such a resin is not available, an epoxy resin which can be cured in the state of being left to stand can be used.

FIG. 1(a) and (b) are SEM images for describing a procedure for calculating "proportion of adhesion" in the present disclosure. In the drawings, the epoxy resin is indicated by black and cross sections of filaments are indicated by white circles.

In FIG. 1(a), a position indicated by an arrow a1 corresponds to an adhesion point between filaments and a position indicated by an arrow a2 does not correspond to such an adhesion point. When a cross section of the glass fabric is observed at a magnification of 2000x with a scanning electron microscope, a position where cross sections of filaments (namely, white circles indicating the cross sections of filaments in an SEM photograph) are contacted with each other by 50 nm or more corresponds to "adhesion point".

The "total number of filaments" and the "number of adhesion points" in the present disclosure are determined under the assumption that filaments whose cross sections are fully included in the observation image are regarded as subjects and counted. A filament whose cross section is partially cut out from the observation image and an adhesion point given from such a filament are not counted for the "total number of filaments" and the "number of adhesion points". As an example in FIG. 1(b), the total number of filaments whose cross sections are fully included in the observation image is 30 in total (see numbers in white portions), the number of adhesion points at which such filaments contact with each other is 18 in total (see sign "×"), and a filament cut out from the observation image is not regarded as a subject of counting for the "total number of filaments" and the "number of adhesion points". Thus, the proportion of adhesion is calculated as 18/30 = 0.6 in an example in FIG. 1(b).

The glass fabric preferably has a proportion of warp yarn adhesion of more than 0 and 0.80 or less as the average with respect to some cross sections, and may have a cross section which does not locally satisfy the range of the proportion of warp yarn adhesion.

[Filament Diameter, and Thickness of Glass Fabric]

A glass yarn having a large diameter relative to the thickness of the glass fabric, for example, one having a larger filament diameter than that prescribed in the IPC standard is preferably used in the glass fabric. More specifically, the average filament diameter (D) ($\mu$m) of the glass yarn constituting the glass fabric and the thickness (T) of the glass fabric ($\mu$m) preferably satisfy the following formula (B1), further preferably satisfy the following formula (B2), particularly preferably satisfy the following formula (B3), (B4) or (B5) when the thickness of the glass fabric is 20 $\mu$m or more and 80 $\mu$m or less. When the thickness of the glass fabric is less than 20 $\mu$m, the following formula (B6) is preferably satisfied, the following formula (B7) is more preferably satisfied, and the following formula (B8) or (B9) is particularly preferably satisfied.

$$24 \times D - T > 96 \, ... \, (B1)$$

$$24 \times D - T > 98 \, ... \, (B2)$$

$$24 \times D - T > 100 \, ... \, (B3)$$

$$24 \times D - T > 104 \, ... \, (B4)$$

$$24 \times D - T > 108 \, ... \, (B5)$$

$$14 \times D - T > 46 \, ... \, (B6)$$

$$14 \times D - T > 48 \, ... \, (B7)$$

$$14 \times D - T > 50 \, ... \, (B8)$$

$$14 \times D - T > 52 \, ... \, (B9)$$

Thus, the strength per filament relative to the thickness of the glass fabric is higher, and the occurrence of fuzz can be suppressed.

[Filament Diameter and Number of Filaments]

A glass yarn having a large filament diameter relative to the thickness of the glass fabric and having a small number of filaments is preferably used in the glass fabric. As long as the number of stacking warp yarn filaments in a bundle satisfies the formula (A1), the filament diameter and the number of filaments are not particularly limited, and the number of filaments in the case of a larger filament diameter is preferably set so that TEX of the glass yarn is at a conventional level, for example, is comparable with TEX prescribed in the IPC standard, or the cross-sectional area of the glass yarn (Cross-sectional area of one filament × Number of filaments) is at a conventional level, for example, is comparable with the cross-sectional area of the yarn type prescribed in the IPC standard. The "comparable" here accepts a difference of ±30% or ±20%. Thus, a sufficient thread count relative to the thickness can be ensured and the problem of slippage or the like is hardly caused.

[Silane Coupling Agent]

The glass yarn (including glass filaments) constituting the glass fabric is preferably subjected to a surface treatment with a surface treatment agent from the viewpoint of enhancements in resin impregnation properties. The surface treatment agent of the glass yarn preferably includes a silane coupling agent. The silane coupling agent used here is preferably, for example, a silane coupling agent represented by the following formula (C):

$$X(R)_{3-n}SiY_n \ldots \qquad (C)$$

in the formula (C), X is an organic group having at least one of an unsaturated double bond group having radical reactivity, such as a carbon-carbon double bond having radical reactivity, and an amino group, Y is each independently an alkoxy group, n is an integer of 1 or more and 3 or less, and R is a group selected from the group consisting of a methyl group, an ethyl group and a phenyl group.

The followings are considered as factors for an increase in dielectric tangent of the glass fabric:

(i) a degraded product by thermal oxidation of a trace amount of a sizing agent, which remains in a state of being physically attached to a glass yarn surface, and

(ii) a residual material of the surface treatment agent which does not form a chemical bond with and is physically attached to a glass surface and which cannot be decreased by washing with water, or a modified product thereof. X in the formula (C) is preferably an organic group not forming a salt with an ionic compound, from the viewpoint of suppression of the occurrence of the degraded product by thermal oxidation (i) and/or the occurrence of the residual material or the modified product thereof (ii). X in the formula (C) is more preferably an organic group having one or more methacryloyloxy groups or acryloyloxy groups from the viewpoint of reactivity with a matrix resin.

The alkoxy group as Y in the formula (C) is preferably an alkoxy group having 1 to 5 carbon atoms (having 1, 2, 3, 4 or 5 carbon atoms) for the purpose of a stable treatment of the glass fabric.

As the surface treatment agent, the silane coupling agent represented by the formula (C) may be used singly, or mixed and used with two or more kinds of such silane coupling agents different in X in the formula (C). Examples of the silane coupling agent represented by the formula (C) include vinyltrimethoxysilane, 3-methacryloyloxypropyltrimethoxysilane, acryloyloxypropyltrimethoxysilane, 3-acryloyloxypropyltrimethoxysilane, 5-hexenyltrimethoxysilane, and any mixture thereof.

The molecular weight of the silane coupling agent is preferably 100 to 600, more preferably 150 to 500, further preferably 200 to 450. In particular, two or more kinds of such silane coupling agents different in molecular weight are particularly preferably used. Two or more kinds of such silane coupling agents different in molecular weight are used to treat a glass yarn surface, thereby resulting in tendencies to increase the treatment agent density on the glass surface and further enhance reactivity with a matrix resin.

The silane coupling agent is preferably non-ionic from the viewpoint of hardly inhibiting reactivity with a resin. Among non-ionic silane coupling agents, a silane coupling agent having at least one group selected from the group consisting of a vinyl group, a methacryloyloxy group, and an acryloyloxy group is preferred, and in particular, a silane coupling agent having at least one methacryloyloxy group or acryloyloxy group is particularly preferred. The reactivity with a resin is not inhibited and thus a printed circuit board can be increased in heat resistance and reliability.

**In** one aspect, X in the formula (C) is an organic group having at least one of the unsaturated double bond group and the amino group. Accordingly, not only an aspect where X has both the unsaturated double bond group and the amino group, but also both an aspect where X has the unsaturated double bond group, but does not have the amino group, and an aspect where X does not have the unsaturated double bond group, but has the amino group are included in the scope of the formula (C). Here, X in the formula (C) is preferably the unsaturated double bond group, and preferably does not contain the amino group.

[Value of Loss of Ignition]

The value of loss of ignition of the glass fabric is preferably in a range of 0.01 wt% to 0.30 wt%, more preferably in a range of 0.02 wt% to 0.26 wt%, further preferably 0.03 wt% to 0.22 wt%, still further preferably 0.03 wt% to 0.18 wt%, particularly preferably 0.03 wt% to 0.16 wt%. When the value of loss of ignition is 0.30 wt% or less, the amount of the silane coupling agent chemically bound with the glass yarn surface is not too large, while depending on the thickness of the glass fabric, and in this case, the dielectric tangent of the glass fabric, and then the dielectric tangent of the resulting printed circuit board is easily reduced. When the value of loss of ignition is 0.01 wt% or more, the heat resistance of the resulting printed circuit board hardly deteriorates.

<<Method for Producing Glass Fabric>>

The method for producing the glass fabric of the present disclosure comprises a process (weaving process) of weaving a glass yarn including a plurality of filaments and having a Si content in a range of 95.0 wt% to 100 wt% in terms of SiO2, as each of a warp yarn and a weft yarn, to obtain a glass fabric. The method further comprises a warping process of paralleling and flattening the glass yarn and then applying a sizing agent, before the weaving process, a process (washing process before heating/de-oiling) of washing the glass yarn before heating/de-oiling, with water at 50°C or more, after the warping process and before, during or after the weaving process, and then a process (heating/de-oiling process) of heating/de-oiling the glass yarn. Thus, adjustment can be made so that the number of stacking warp yarn filaments in a bundle and the thickness of the glass fabric satisfy the formula (A1), and a quartz glass fabric less causing fuzz can be provided. The method can further comprise a process (washing/filament-opening process) of washing and filament-opening the glass yarn washed and heated/de-oiled, with conveying the glass yarn at a speed of 50 m/min or less in a liquid being irradiated with ultrasound. Thus, adjustment can be made so that the number of stacking warp yarn filaments in a bundle and the thickness of the glass fabric satisfy the formula (A1) and also the proportion of warp yarn adhesion is equal to or less than a predetermined value, and a quartz glass fabric can be provided which less causes fuzz and which has excellent resin impregnation properties and can allow heat resistance of a printed circuit board or the like to be enhanced.

The above glass treatment method (washing process before heating/de-oiling, heating/de-oiling process, and washing/filament-opening process) can be applied to a glass yarn before weaving, and can also be applied to the glass fabric woven. In other words, the process of weaving the glass yarn to obtain the glass fabric may be provided before, during or after the glass treatment method. The "decreasing" in the glass treatment method is intended to remove at least one portion of, for example, the sizing agent or the silane coupling agent, and the remaining substance which cannot be completely removed may also be present. Hereinafter, an aspect in which the warping process, the weaving process, the washing process before heating/de-oiling, the heating/de-oiling process, and the washing/filament-opening process are included in the listed order is described as an example. However, the method for producing the glass fabric of the present disclosure is not limited thereto.

[Warping Process of Glass Yarn]

The warping process of a glass yarn includes a process of using a glass yarn having a Si content in a range of 95.0 wt% to 100 wt% in terms of $SiO_2$, flattening a yarn bundle thereof, and then sizing the glass yarn. According to the treatment, gluing can be performed in a state where the yarn width is broadened, thereby facilitating broadening of the yarn width in a state of the glass fabric after weaving, allowing for control so that the number of stacking warp yarn filaments in a bundle and the thickness of the resulting glass fabric satisfy the formula (A1) and allowing for suppression of fuzz. In other words, unevenness in a surface and a yarn bundle of the glass fabric is suppressed and fuzz is hardly caused. A method for flattening a glass yarn bundle is not particularly limited, and examples include a method such as a processing treatment under pressure with a roller. The pressure is preferably 1.0 kg/cm$^2$ to 6.0 kg/cm$^2$, more preferably 2.0 kg/cm$^2$ to 5.0 kg/cm$^2$, further preferably 2.5 kg/cm$^2$ to 5.5 kg/cm$^2$ from the viewpoint of not only suppression of fuzz, but also flattening of the yarn bundle. The warping process facilitates removal of a gluing agent in a subsequent washing process before heating/de-oiling.

[Weaving Process of Glass Fabric Greige]

In the weaving process of a glass fabric greige, weaving can be performed by beating a glass yarn having a Si content in a range of 95.0 wt% to 100 wt% in terms of $SiO_2$, as a weft yarn, to a warp yarn prepared in the warping process of a glass yarn, with a weaving machine. Thus, for example, a glass fabric greige being a woven fabric of a plain-woven structure can be produced. The glass yarn used in the glass fabric greige is preferably subjected to a surface treatment with a sizing agent mainly containing starch, polyvinyl alcohol, or the like in order to suppress fuzz during the spinning and warping of the glass yarn. In the present disclosure, the "glass fabric greige" refers to a glass fabric before heating/de-oiling.

A glass yarn having a large diameter relative to the thickness of the resulting glass fabric, for example, one having a larger filament diameter than that prescribed in the IPC standard is preferably used in a glass yarn used in the process, namely, the warping process of a glass yarn and the weaving process of a glass fabric greige. More specifically, a glass yarn having a filament diameter satisfying at least one of the formulae (B1) to (B9) is preferably used depending on an objective thickness of the glass fabric. Thus, the occurrence of fuzz is suppressed and resin impregnation properties are easily enhanced. TEX, or the cross-sectional area of the glass yarn used in the above process, relative to the thickness of the resulting glass fabric, is at a conventional level; for example, TEX or the cross-sectional area prescribed in the IPC standard. Thus, a sufficient thread count relative to the thickness can be ensured and the problem of slippage or the like is hardly caused.

[Washing Process before Heating/De-sizing]

The washing process before heating/de-oiling includes a process of washing the glass fabric before heating/de-oiling, with water at 50°C or more, to decrease a gluing agent. Thus, adhesion by combustion residues of a gluing agent of filaments and a gluing agent during heating/de-oiling can be decreased, and control can be made so that the number of stacking warp yarn filaments in a bundle and the thickness of the resulting glass fabric satisfy the formula (A1). Furthermore, the filament-opening treatment of the glass fabric is easily performed so that the proportion of warp yarn adhesion is equal to or less than a predetermined value. The solvent used for washing in the treatment is preferably water from the viewpoint of the washing efficiency, and the temperature is preferably 50°C or more. Use of water at 50°C or more not only allows a required amount of the gluing agent for protection of the glass yarn until the heating/de-oiling process to remain, but also can allow an excess gluing agent to be washed. The temperature of water is preferably 50°C or more and less than 100°C. The lower limit value of the temperature of water is more preferably 55°C or more, further preferably 60°C or more, still further preferably 65°C or more. The upper limit value of the temperature of water, which can be combined with such a lower limit value, is more preferably 95°C or less, further preferably 90°C or less. The solvent used for washing is not particularly limited, and washing with water, reverse osmosis (RO) water, ion-exchange water, or the like is preferred from the viewpoint of safety and cost. The method for washing the glass fabric greige is not particularly limited, and is considered to be, for example, a method such as a procedure with ultrasound (for example, procedure with an ultrasonic vibrator), atomization by spraying (for example, atomization by high-pressure spraying), or water vapor misting. A method including immersing the glass fabric greige in a tank in which a washing liquid is stored, then removing an excess washing liquid by a squeeze roller or the like, and thereafter drying the glass fabric greige is preferred from the viewpoint that processing can be inexpensively made. In this case, the immersion time may be, for example, 2 seconds or more, 5 seconds or more, 10 seconds or more, or 15 seconds or more, and 120 seconds or less, 90 seconds or less, 60 seconds or less, or 45 seconds or less.

[Process (Heating/De-oiling Process) of Decreasing Sizing Agent]

The process of decreasing a sizing agent can have, for example, a de-sizing process (heating/de-oiling process) of heating the glass fabric greige at a temperature of 600°C to 1600°C. Thus, a sizing agent is easily decreased from glass. A degraded product by thermal oxidation of a trace amount of a sizing agent in a state of being attached to a glass surface and remaining on the glass surface is decreased, thereby effectively suppressing an increase in dielectric tangent of the resulting glass fabric.

In the heating/de-oiling method of the glass fabric greige, the glass fabric greige may be heated/deoiled at a temperature of 600°C or more. Thus, the dielectric tangent of the resulting glass fabric is easily reduced. The temperature of heating/de-oiling is preferably 600°C or more and 1600°C or less, more preferably 800°C or more and 1300°C or less, further preferably 900°C or more and 1100°C or less. When the heating/de-oiling temperature is 600°C or more, a residual material or the like of a gluing agent attached to the glass fabric after heating/de-oiling is sufficiently removed, and therefore the dielectric tangent of the glass fabric is easily reduced. On the other hand, when the heating/de-oiling temperature is 1500°C or less, a devitrification phenomenon of glass is easily suppressed, and a reduction in strength of the glass fabric can be effectively prevented.

The heating time can be appropriately selected and is preferably 1 second or more and 10 minutes or less. The upper limit value of the heating time is more preferably 5 minutes or less, further preferably 2 minutes or less, particularly preferably 90 seconds or less. Since heating treatment is performed at a high temperature, a heating time of 10 minutes or less reduces damage to the glass fabric, and hardly causes the problem of, for example, partial perforating of the glass fabric or cutting of the glass fabric during processing. The lower limit value of the heating time, which can be combined with such an upper limit value, may be more preferably 5 seconds or more, 10 seconds or more, or 15 seconds or more from the viewpoint of effective removal of a residual material or the like of a gluing agent.

Known heating method, heating medium, heating mechanism, heating apparatus, and heating part can be used in the tool for heating the glass fabric greige as long as heating is performed so that the heating/de-oiling temperature is in a range of 600°C to 1600°C. The heating tool may be, for example, (1) to heat the glass fabric greige in a heating furnace, (2) to contact the glass fabric greige with a heating portion, or (3) to apply high-temperature vapor to the glass fabric greige. The glass fabric greige can be heated so that the heating/de-oiling temperature is 600°C or more, thereby allowing an organic substance attached to a glass fabric greige surface to be efficiently removed and/or allowing the removal time of the organic substance to be shortened. The glass fabric greige can be heated sequentially or continuously in a closed system or an open system, or can be heated with a combination of a closed system and an open system.

In the case of a closed system, the glass fabric greige is preferably placed in a heating furnace from the viewpoint of suitable heating with the heating tool, and/or the glass fabric greige is preferably heated with being stored in the form of a wound product, from the viewpoint of a storage space and a heating range. The glass fabric greige is also preferably heated with being conveyed in a heating furnace from the viewpoint of an increase in removal efficiency of the organic substance and a decrease in removal time of the organic substance.

In the case of an open system, the glass fabric greige is preferably heated with being conveyed from the viewpoint of the area to be heated. The glass fabric greige can be conveyed with, for example, an unwinding mechanism and a winding mechanism, for example, a Roll-to-Roll system.

(Heating Furnace)

The heating tool of the heating furnace is considered to be any of various tools such as an electrical heater and a burner, as long as heating can be made so that the heating/de-oiling temperature is 600°C to 1600°C, and is not limited to only a particular tool. Heating may also be made with a combination of a plurality of tools, and a gas-type single radiant tube burner or an electrical heater is preferably used.

The heating furnace preferably includes a tool for emitting a gas generated in the heating furnace, and/or an air circulation tool from the viewpoint of the heating efficiency. The gas emission tool may be, for example, a nozzle, a gas tube, a small hole, or a degassing valve. The air circulation tool may be, for example, a fan or air-conditioning equipment.

In order to efficiently remove an organic substance attached to a glass fabric greige surface, a continuous system in which the glass fabric greige can be heated with continuously passing through the heating furnace is more preferred than a batch system in which a glass fiber woven fabric is wound around a core and the glass fabric greige is heated at a predetermined atmosphere temperature. Furthermore, a system in which washing of the glass fabric before heating/de-oiling (glass fabric greige) can be continuously performed is particularly preferred.

(Contact Member for Heating Glass Fabric Greige)

The heating furnace may be used in the method for heating the glass fabric greige, and the glass fabric greige may be heated by contacting a member heated to a predetermined temperature and the glass fabric greige, from the viewpoint of a low running cost.

The shape of the contact member is not particularly limited as long as heating can be made so that the heating/de-oiling temperature of the glass fabric greige is in a range of 600°C to 1600°C, and the shape is preferably a roller shape from the viewpoint of ease of conveyance of the glass fabric greige. The member which can have a roller shape to heat the glass fabric greige is preferably a roller which can be used in a high temperature region, which is relatively less varied in temperature in the width direction, and which provides warming in an induction heat generation system. When the glass fabric greige is heated with the contact member, the temperature of the contact member and the surface temperature of the glass fabric greige are considered to be substantially equal to each other.

In order to remove carbide attached to a heating roller as the glass fabric greige is continuously heated, the heating roller system is preferably a system including a mechanism for removal of a foreign substance attached, for example, a mechanism such as a blade.

(Tool (Vapor Application Tool) for Application of High-Temperature Vapor to Glass Fabric Greige)

The vapor applied to the glass fabric greige may contain, for example, a volatile solvent, water vapor, and/or a gas other than water vapor, and is preferably water vapor from the viewpoint of toxicity to the human body and from the viewpoint of ease of promotion of decomposition of a binding agent used for glass fibers. In order that the temperature of the high-temperature vapor, in terms of the surface temperature of the glass fabric greige, is in a range of 600°C to 1600°C, a method is preferably used which can supply the high-temperature vapor and heating air at any ratio. The temperature of the high-temperature vapor is 500°C or more, preferably 600°C or more, more preferably 700°C or more, further preferably 800°C or more, particularly preferably 900°C or more. The vapor application tool is not limited, and may be atomization, shower diffusion, a jet nozzle, or the like. Alternatively, a gas emitted from the heating furnace may be reused as the high-temperature vapor.

(Heating/De-oiling Apparatus of Glass Fabric Greige)

The heating/de-oiling apparatus of the glass fabric greige can heat the glass fabric greige so that the heating/de-oiling temperature is in a range of 600°C to 1600°C, as described above. More specifically, the heating/de-oiling apparatus of the glass fabric greige preferably has an unwinding mechanism and a winding mechanism and includes a heating furnace in which a process of conveying and also heating the glass fabric greige so that the heating/de-oiling temperature is in a range of 600°C to 1600°C can be carried out.

The unwinding mechanism and the winding mechanism may be, for example, at least a pair of rollers, or a Roll-to-Roll system. The heating furnace, the air circulation tool, the contact member, and the vapor application tool are as described above with respect to the heating treatment process of the glass fabric greige.

A washing apparatus for washing off a sizing agent of the glass fabric greige is preferably provided in front of the heating furnace from the viewpoint of the production efficiency.

[Fiber-Opening Process of Glass Fabric]

The filament-opening process of the glass fabric after heating/de-oiling includes a process of the filament-opening treatment of the glass fabric so that the number of stacking warp yarn filaments in a bundle and the thickness of the resulting glass fabric satisfy the formula (A1) and the proportion of warp yarn adhesion is equal to or less than a predetermined value. The filament-opening treatment can enhance resin impregnation properties of the glass fabric. Examples of the filament-opening treatment include a filament-opening treatment including applying the pressure of water flow to the glass fabric; a filament-opening treatment with, as a medium, water (for example, degassed water, ion-exchange water, deionized water, electrolytic cation water or electrolytic anion water) or the like by high-frequency vibration; and a processing treatment with a roller under pressure. Such a filament-opening treatment may be performed at the same time as formation by weaving or after formation by weaving. Such a filament-opening treatment may be performed before or after heating/de-oiling, or at the same time as heating/de-oiling, and/or may be performed at the same time as or after a surface treatment process.

The filament-opening process is preferably a process of washing and filament-opening the glass fabric with conveying the glass fabric in a liquid after the heating/de-oiling process and before a surface treatment process from the viewpoint of controlling the number of stacking warp yarn filaments in a bundle and the proportion of warp yarn adhesion in the glass fabric which is constituted from a glass yarn having a relatively large filament diameter, namely, satisfying any of the formulas (B1) to (B9) and which has a thickness of 80 $\mu$m or less, in predetermined ranges. The conveying speed of the glass fabric in the treatment is preferably 50 m/min or less. A glass yarn having a large filament diameter is hardly filament-opened and, in particular, a glass yarn having a high glass hardness, such as quartz glass, is more hardly filament-opened. The glass fabric can be washed and filament-opened after the heating/de-oiling process and before a surface treatment process, thereby allowing a combustion residue during heating/de-oiling to be washed and removed, and preventing filaments from adhering to each other due to action of such a combustion residue as an adhesive. Such filament-opening can be made before a surface treatment, thereby preventing filaments from adhering to each other in a surface treatment process. Thus, control can be made so that the proportion of warp yarn adhesion in the glass fabric satisfies a predetermined range, and resin impregnation properties are enhanced. Such filament-opening not is made, but can be easily made, by simply strong processing force, and therefore fuzz is also hardly caused.

The washing/filament-opening process of the glass fabric is preferably a process (ultrasonic washing) of irradiating the glass fabric after the heating/de-oiling process and before a surface treatment process, with ultrasound in a liquid, to wash off mainly a combustion residue of heating/de-oiling from the glass fabric and fiber-open the glass fabric. The process is preferably a process of performing a treatment by conveying the glass fabric in a Roll-to-Roll manner by an ultrasonic oscillator in a liquid being irradiated with ultrasound.

The liquid used for ultrasonic washing can be any of water or an organic solvent, and is preferably a liquid mainly containing water, from the viewpoint of safety and global environment protection. A surfactant or a pH adjuster can also be added to the liquid used for washing, in order to increase the efficiency of washing.

The temperature of the liquid used for ultrasonic washing is not particularly restricted, and is preferably 5°C or more from the viewpoint of an enhancement in washing effect. The temperature of the liquid used for washing is preferably 60°C or less from the viewpoint of safety.

The glass fabric can be traveled in a liquid being irradiated with ultrasound by an ultrasonic oscillator, and thus the glass fabric can be irradiated with ultrasound and washed in the liquid. The line tension acting on the warp yarn in the washing process is preferably 30 N to 500 N/1 m.

The ultrasonic washing can be made with ultrasound having a frequency of 20 kHz or more and 200 kHz or less. The frequency of ultrasound is preferably 20 kHz or more and 50 kHz or less, more preferably 20 kHz or more and 30 kHz or less. Such ultrasound having a frequency of 20 kHz or more and 200 kHz or less is preferably used because a washing treatment can be performed without any large defect such as bowed filling of the glass fabric.

In ultrasonic washing, ultrasound having an output of 0.07 W/cm$^2$ or more and 3.60 W/cm$^2$ or less can be preferably used. A more preferred range of the output of ultrasound is 0.14 W/cm$^2$ or more and 2.16 W/cm$^2$ or less, and a further preferred range thereof is 0.21 W/cm$^2$ or more and 1.44 W/cm$^2$ or less. An output of ultrasound of 0.07 W/cm$^2$ or more is preferred because favorable washing can be performed, and an output of ultrasound of 3.60 W/cm$^2$ or less is preferred because the occurrence of bowed filling or the like is not caused and uniform washing can be performed.

The conveying speed of the glass fabric in ultrasonic washing is preferably 50 m/min or less, further preferably 40 m/min or less, particularly preferably 30 m/min or less. When the conveying speed of the glass fabric is 50 m/min or less, the glass fabric or an intermediate thereof can be favorably washed and filament-opened, and the number of stacking warp yarn filaments in a bundle and the proportion of warp yarn adhesion are more easily controlled in predetermined ranges. Such a conveying speed is also preferred because fuzz and/or slippage due to damage in conveyance can be suppressed.

While air mainly containing nitrogen and oxygen is usually dissolved in the liquid used for ultrasonic washing, the amount of dissolved oxygen (weight ratio) is preferably 1 ppm or more and 20 ppm or less, a more preferred range is 3 ppm or more and 17 ppm or less, and a further preferred range is 4 ppm or more and 14 ppm or less. The amount of dissolved oxygen can be regulated to allow for indirect control of the amount of dissolved gas and allow for control of the degree of attenuation of ultrasound due to the dissolved gas. An amount of dissolved oxygen of 1 ppm or more is preferred because a filament-opening treatment is uniformly applied. An amount of dissolved oxygen of 20 ppm or less is preferred because favorable washing action is imparted to a fiber fabric. An amount of dissolved oxygen in a range of 1 ppm or more and 20 ppm or less is preferred because a uniform and favorable filament-opening effect is obtained.

[Surface Treatment Process of Glass Fabric]

The method for producing the glass fabric of the present disclosure may further comprise a process of subjecting the glass fabric to a surface treatment with a surface treatment agent. A process of attaching the surface treatment agent can have, for example, at least one process of a covering process of attaching the surface treatment agent to a glass surface and a fixing process of fixing the surface treatment agent to a glass surface by heating and drying. Thus, glass is suitably easily subjected to a surface treatment.

Examples of the method for attaching the surface treatment agent include a method including coating the glass fabric with a treatment solution containing the surface treatment agent or a method including immersing the glass fabric in a treatment solution. The method for coating glass with a treatment solution in the covering process can be, for example, (a) a method including immersing glass in a treatment solution stored in a bath or allowing the glass to pass through the treatment solution (hereinafter, referred to as "immersion method"), or (b) a method including coating glass with a treatment solution by a roll coater, a die coater, a gravure coater or the like. When the immersion method is adopted, the immersion time of the glass in the treatment solution is preferably selected to be 0.5 seconds or more and 1 minute or less. When the immersion method is adopted, the glass can be allowed to pass into the treatment solution at a conveying speed of 10 to 50 m/min with application of a predetermined tension (for example, 100 to 250 N) to the glass. After the glass is coated with the treatment solution, a solvent included in the treatment solution can be heated and dried by a method with hot air, electromagnetic waves, or the like.

The concentration of the surface treatment agent included in the treatment solution is preferably 0.1 to 1.0 wt%, more preferably 0.1 to 0.8 wt%, further preferably 0.1 to 0.5 wt%. Thus, glass is more suitably easily subjected to a surface treatment.

The heating and drying temperature in the fixing process is preferably 80°C or more, more preferably 90°C or more so that reaction of the surface treatment agent, for example, the silane coupling agent with the glass is sufficiently performed. The heating and drying temperature is preferably 300°C or less, more preferably 180°C or less in order to prevent degradation of the organic group in the surface treatment agent, for example, the silane coupling agent.

[Fiber-Opening Process after Surface Treatment]

For example, a method for filament-opening processing of the glass fabric by spray water (high-pressure water filament-opening), a vibrowasher, ultrasonic water, a mangle, or the like can be adopted as the process of filament-opening glass filaments adhering by the surface treatment agent. The tension applied to the glass fabric during this filament-opening processing is decreased to result in a tendency to enable the yarn width to be more widened. It is here preferable for suppression of the occurrence of fuzz in the glass fabric due to the filament-opening processing to take measures such as a reduction in friction with the contact member during glass yarn weaving, and optimization of the surface treatment agent and an increase in amount of attachment of the surface treatment agent.

The respective processes described above do not necessarily need to be performed as separate processes, and a plurality of the processes can also be collectively performed as one process. The composition of the glass fabric is not usually changed before and after filament-opening in many cases. The method for producing the glass fabric can also have any process other than the above processes. For example, the method can have a slit-machining process after the filament-opening process. If possible, the order of the processes can be interchanged.

According to the method for producing the glass fabric as described above, not only the filament diameter can be increased and the occurrence of fuzz can be suppressed, but also the number of stacking warp yarn filaments in a bundle and the proportion of warp yarn adhesion can be adjusted in predetermined ranges and resin impregnation properties can be enhanced. The glass fabric of the present disclosure can be used as, for example, a material for producing a printed circuit board.

<<Prepreg>>

the prepreg of the present disclosure contains the glass fabric, and a matrix resin with which the glass fabric is impregnated. Thus, a prepreg with few voids can be provided.

A thermosetting resin or a thermoplastic resin can be used as the matrix resin. If possible, both the resins may be used in combination, or any other resin may be further contained.

Examples of the thermosetting resin include

(a) an epoxy resin obtained by reacting and curing a compound having an epoxy group, and a compound having at least one group selected from the group consisting of an amino group, a phenol group, an acid anhydride group, a hydrazide group, an isocyanate group, a cyanate group and a hydroxyl group reactive with the epoxy group;

(b) a radical-polymerization cured resin obtained by curing a compound having at least one group selected from the group consisting of an allyl group, a methacrylic group and an acrylic group;

(c) a maleimide-triazine resin obtained by curing a compound having a cyanate group and a compound having a maleimide group;

(d) a thermosetting polyimide resin obtained by reacting and curing a maleimide compound and an amine compound; and

(e) a benzoxazine resin obtained by crosslinking and curing a compound having a benzoxazine ring, by heating polymerization.

When the epoxy resin (a) is obtained, the compounds can be reacted with no catalyst, or the compounds can also be reacted with addition of a catalyst having reaction catalytic ability, such as an imidazole compound, a tertiary amine compound, a urea compound, and a phosphorus compound. When the radical-polymerization cured resin (b) is obtained, a thermal decomposition type catalyst or an optical decomposition type catalyst can be used as a reaction initiator.

Examples of the thermoplastic resin include polyphenylene ether, modified polyphenylene ether, polyphenylene sulfide, polysulfone, polyether sulfone, polyarylate, aromatic polyamide, polyetheretherketone, thermoplastic polyimide, insoluble polyimide, polyamide imide, and a fluororesin. The insulation material of a printed circuit board for high-speed communication is preferably polyphenylene ether or modified polyphenylene ether rich in radical reactivity.

When the matrix resin used in a printed circuit board for high-speed communication has a vinyl group or a methacrylic group, a silane coupling agent having a hydrocarbon group which is relatively high in hydrophobicity and which involves in radical reaction of a methacrylic group or the like is good in compatibility with the matrix resin.

As described above, the thermosetting resin and the thermoplastic resin can be used in combination. The prepreg can further contain an inorganic filler. The inorganic filler is preferably used in combination with the thermosetting resin, and examples thereof include aluminum hydroxide, zirconium oxide, calcium carbonate, alumina, mica, aluminum carbonate, magnesium silicate, aluminum silicate, silica, talc, a short glass fiber, aluminum borate, and silicon carbide. The inorganic filler may be used singly or in combination of two or more kinds thereof.

<<Printed Circuit Board>>

The printed circuit board of the present disclosure contains one or a plurality of the prepregs. **In** other words, the printed circuit board has the glass fabric, and a cured product of a matrix resin composition with which the glass fabric is impregnated. The printed circuit board is high in adhesiveness with resins and is excellent in dielectric characteristics.

<<Integrated Circuit and Electronic Device>>

According to the present disclosure, an integrated circuit and an electronic device each comprising the printed circuit board are also provided. An integrated circuit and an electronic device each obtained with the printed circuit board of the present disclosure are excellent in various characteristics.

EXAMPLES

Examples and Comparative Examples of the present disclosure are described, but the present disclosure is not limited by the following Examples and Comparative Examples.

<<Measurement and Evaluation Methods>>

[Physical Properties of Glass Yarn and Glass Fabric]

Physical properties of the glass yarn and the glass fabric, specifically, the number of filaments, the beating densities (weaving densities) of the warp yarn and the weft yarn, the thickness of the glass fabric, and the value of loss of ignition of the glass fabric were measured according to JIS R3420.

[Average Filament Diameter of Glass Yarn]

The cross sections of 30 glass yarn bundles at any location of the glass yarn were observed with a scanning electron microscope, and the average value was calculated to determine the average filament diameter.

[Average Number of Filaments of Glass Yarn]

The average value with respect to the number of filaments measured according to JIS R3420 was calculated to determine the average number of filaments.

[Yarn Widths of Warp Yarn and Weft Yarn]

The respective average values of the yarn widths of the warp yarn and the weft yarn of the glass fabric were determined with photographing and scanning at an interval of 1 mm in the MD direction or the TD direction of the glass fabric with a camera having a view field size of about $2.3 \times 1.7$ mm and a resolution of 2.26 $\mu$m/Pixel. The respective average values of the yarn widths were determined with respect to the yarn widths derived from 100 or more of the glass yarns.

[Calculation of Proportion of Warp Yarn Adhesion]

The glass fabric was embedded in an epoxy resin (Epomount (trade name), curing agent II, manufactured by Refine Tec Ltd.), and the epoxy resin was cured. A cross section of the glass fabric together with the resin was machined and polished so that the circularity of a glass filament was 0.9 or more, and thereafter cross section of the glass fabric was observed at a magnification of 2000x with a scanning electron microscope SU3500 manufactured by Hitachi High-Technologies. One warp yarn was divided into thirds, and cross section images of five of such yarns in total were taken. Thereafter, the total number of filaments and the number of adhesion points of filaments whose cross sections were contacted by 50 nm or more in each image were visually counted. The proportion of warp yarn adhesion was calculated by the following formula: Proportion of warp yarn adhesion = Number of adhesion points of filaments adhering to each other in warp yarn/Number of warp yarn filaments

The resulting 15 images were subjected to the same operation, and the average value was defined as the proportion of warp yarn adhesion.

[Evaluation Method of Fuzz]

The glass fabric was visually observed under application of a tension of 100 N/1000 mm with irradiation by a halogen lamp on a Roll-to-Roll examination table, to determine the number of protruded positions of 1 mm or more, per square meter, and fuzz was evaluated according to the following criteria.

A: the number of pieces of fuzz: 10 or less
B: the number of pieces of fuzz: 11 or more and 30 or less
C: the number of pieces of fuzz: 31 or more and 60 or less
D: the number of pieces of fuzz: 61 or more

[Measurement/Evaluation Methods of Resin Impregnation Properties]

The glass fabric was sampled so as to have a size of 50 mm $\times$ 50 mm or more. Here, such sampling was performed so that a measurement position was not bent or touched. Evaluation was made by counting the number of voids in impregnation of the sampled glass fabric with castor oil (manufactured by Hayashi Pure Chemical Ind., Ltd., item number: 03001535, static viscosity at 24°C = 560 mPa·s $\times$ g/cm$^3$) at a liquid temperature of 24°C for a predetermined time. A high-accuracy camera (frame size: 5120 $\times$ 5120 pixels) was disposed at a position in a direction perpendicular to the glass fabric, and the glass fabric was irradiated with LED light (manufactured by CCS Inc., power flash/bar type illumination) as a light source from an immediately lateral position apart from the glass fabric by 15 cm, from both sides so that the glass fabric was sandwiched. The number of voids of 160 $\mu$m or more present between glass filaments at a view angle of 32 mm $\times$ 32 mm was counted, and the average value in measurement performed three times was defined as the number of voids. Such a void corresponds to a portion unimpregnated with a matrix resin. Accordingly, a small number of voids in the glass fabric means that the glass fabric is excellent in impregnation properties with a matrix resin.

Resin impregnation properties were evaluated according to the following criteria. The period from immersion of a glass fabric test piece in a varnish for impregnation until counting of the number of sites not impregnated was set to 3 minutes.

A: the number of sites not impregnated: 80 or less
B: the number of sites not impregnated: 81 or more and 160 or less
C: the number of sites not impregnated: 161 or more and 200 or less
D: the number of sites not impregnated: 201 or more and 250 or less
E: the number of sites not impregnated: 251 or more

[Production Method of Stacked Plate]

The glass fabric obtained in each of Examples and Comparative Examples was adopted, 45 parts by weight of polyphenylene ether (manufactured by SABIC, Noryl (trade name) SA9000), 10 parts by weight of triallyl isocyanurate, 45 parts by weight of toluene, and 0.6 parts by weight of 1,3-di(tert-butylisopropylbenzene) were added to a stainless container, and the mixture was stirred at room temperature for 1 hour, to produce a varnish. The glass fabric was impregnated with the varnish produced, and then dried at 115°C for 1 minute, and then a prepreg was obtained. Eight of such prepregs obtained were stacked, copper foil having a thickness of 12 $\mu$m was stacked on and under a stacked product of such prepregs, and the resultant was heated and pressurized at 200°C and 40 kg/cm² for 120 minutes, to obtain a stacked plate.

[Evaluation Method of Heat Resistance of Stacked Plate]

After the copper foil of the stacked plate obtained as described above was removed by an etching treatment, heating and water absorption were performed in a pressure cooker vessel at 133°C over 70 hours. Furthermore, the stacked plate after water absorption was immersed in a solder bath at 288°C for 20 seconds, and the presence of swelling of 0.03 cm² or more due to peeling at an interface between the glass fabric and the resin was visually confirmed. The test was carried out six times with respect to each of such stacked plates. Evaluation of heat resistance is as follows. It is here indicated that, as swelling in such stacked plates tends to be less confirmed, heat resistance is more excellent.

A: no swelling confirmed in all of six stacked plates.
B: swelling confirmed in one stacked plate.
C: swelling confirmed in two stacked plates.
D: swelling confirmed in three stacked plates.
E: swelling confirmed in four to six stacked plates.

<<Production Examples>>

[Example 1]

Warp yarn warping was performed with a silica glass yarn having a compositional amount of $SiO_2$ of more than 99.9 wt% and having an average filament diameter of 7.5 $\mu$m, a number of filaments of 50, and a number of twists of 1.0 Z. The warp yarn paralleled at a conveying speed of 60 m/min was nipped with a roller under a load of 3.0 kg/cm², to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a glass fabric greige at a thread count of 66 warp yarns/inch and 68 weft yarns/inch. Here, weaving was performed so that the fabric width was 1300 mm. The weft yarn used here was a silica glass yarn having an average filament diameter of 7.5 $\mu$m, a number of filaments of 50, and a number of twists of 1.0 Z.

While the glass fabric greige obtained was conveyed at a line speed so as to be immersed for 15 seconds in a water tank with ion-exchange water at 60°C stored, the sizing agent attached to a glass surface was washed (washing process before de-oiling). Thereafter, the glass fabric greige was deoiled by heating in a heating furnace provided on the same line, with a Roll-to-Roll system at 1000°C for 30 seconds, to obtain a glass fabric (heating/de-oiling process). Next, the glass fabric, with being travelled in water at a conveyance tension of 200 N and a line speed of 30 m/min, was irradiated with ultrasound at a frequency of 25 GHz and an output of 0.72 W/cm$^2$, to perform washing of the residue (washing/filament-opening process). Subsequently, a treatment solution was adjusted in which 0.3 wt% of 3-methacryloyloxypropyltrimethoxysilane; Z6030 (manufactured by Dow Toray Co., Ltd.) was dispersed in pure water adjusted to a pH of 3 with acetic acid. The fabric was immersed in the treatment solution, squeezed, and then heated and dried at 130°C for 60 seconds, to perform fixing of such a silane coupling agent. The fabric dried was filament-opened with spray at a high pressure of 3.0 kg/cm$^2$ (filament-opening process after surface treatment), and thereafter dried at 130°C for 1 minute, to obtain a glass fabric. The glass fabric obtained was measured with respect to the thickness, the warp yarn width, the weft yarn width, (Number of stacking warp yarn filaments in a bundle - 0.2)/T value, the proportion of warp yarn adhesion, $24 \times D$ - T value, $14 \times D$ - T value, and the value of loss of ignition. Evaluation of fuzz and resin impregnation properties was also performed. Furthermore, a stacked plate was produced by the above method, and heat resistance was evaluated.

[Example 2]

Warp yarn warping was performed with a silica glass yarn having a compositional amount of $SiO_2$ of more than 99.9 wt% and having an average filament diameter of 9.0 $\mu$m, a number of filaments of 34, and a number of twists of 1.0 Z. The warp yarn paralleled at a conveying speed of 60 m/min was nipped with a roller under a load of 3.0 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 66 warp yarns/inch and 68 weft yarns/inch. Here, weaving was performed so that the fabric width was 1300 mm. The weft yarn used here was a silica glass yarn having an average filament diameter of 9.0 $\mu$m, a number of filaments of 34, and a number of twists of 1.0 Z. A glass fabric of Example 2 was obtained in the same procedure as in Example 1 except that the glass fabric greige obtained was used and conditions were changed as described in the Table.

[Example 3]

Warp yarn warping was performed with a silica glass yarn having a compositional amount of $SiO_2$ of more than 99.9 wt% and having an average filament diameter of 7.5 $\mu$m, a number of filaments of 96, and a number of twists of 1.0 Z. The warp yarn paralleled at a conveying speed of 60 m/min was nipped with a roller under a load of 3.5 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 54 warp yarns/inch and 54 weft yarns/inch. Here, weaving was performed so that the fabric width was 1300 mm. The weft yarn used here was a silica glass yarn having an average filament diameter of 7.5 $\mu$m, a number of filaments of 96, and a number of twists of 1.0 Z. A glass fabric of Example 3 was obtained in the same procedure as in Example 1 except that the glass fabric greige obtained was used, the tension in the washing/filament-opening process was 250 N, and conditions were changed as described in the Table.

[Example 4]

Warp yarn warping was performed with a silica glass yarn having a compositional amount of $SiO_2$ of more than 99.9 wt% and having an average filament diameter of 6.0 $\mu$m, a number of filaments of 22, and a number of twists of 0.6 Z. The warp yarn paralleled at a conveying speed of 60 m/min was nipped with a roller under a load of 3.0 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 95 warp yarns/inch and 95 weft yarns/inch. Here, weaving was performed so that the fabric width was 1300 mm. The weft yarn used here was a silica glass yarn having an average filament diameter of 6.0 $\mu$m, a number of filaments of 22, and a number of twists of 0.6 Z. A glass fabric of Example 4 was obtained in the same procedure as in Example 1 except that the glass fabric greige obtained was used and conditions were changed as described in the Table.

[Comparative Example 1]

Warp yarn warping was performed with a silica glass yarn having a compositional amount of $SiO_2$ of more than 99.9 wt% and having an average filament diameter of 5.0 $\mu$m, a number of filaments of 100, and a number of twists of 1.0 Z. The warp yarn paralleled at a conveying speed of 60 m/min was nipped with a roller under a load of 3.0 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 66 warp yarns/inch and 68 weft yarns/inch. Here, weaving was performed so that the fabric width was 1300 mm. The weft yarn used here was a silica glass yarn having an average filament diameter of 5.0 $\mu$m, a number of filaments of 100, and a number of twists of 1.0 Z. A glass fabric of Comparative Example 1 was obtained with the glass fabric greige obtained, in the same procedure as in Example 1.

[Comparative Example 2]

A glass fabric of Comparative Example 2 was obtained in the same procedure as in Example 1 except that the glass fabric greige obtained in Comparative Example 1 was used and conditions were changed as described in the Table.

[Comparative Example 3]

Warp yarn warping was performed with a silica glass yarn having a compositional amount of $SiO_2$ of more than 99.9 wt% and having an average filament diameter of 5.0 $\mu$m, a number of filaments of 200, and a number of twists of 1.0 Z. The warp yarn paralleled at a conveying speed of 60 m/min was nipped with a roller under a load of 3.5 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 54 warp yarns/inch and 54 weft yarns/inch. Here, weaving was performed so that the fabric width was 1300 mm. The weft yarn used here was a silica glass yarn having an average filament diameter of 5.0 $\mu$m, a number of filaments of 200, and a number of twists of 1.0 Z. A glass fabric of Comparative Example 3 was obtained with the glass fabric greige obtained, in the same procedure as in Example 3.

[Comparative Example 4]

Warp yarn warping was performed with a silica glass yarn having a compositional amount of $SiO_2$ of more than 99.9 wt% and having an average filament diameter of 4.0 $\mu$m, a number of filaments of 50, and a number of twists of 0.6 Z. The warp yarn paralleled at a conveying speed of 60 m/min was nipped with a roller under a load of 3.0 kg/cm$^2$, to flatten the glass yarn. Thereafter, a sizing agent mainly containing a polyvinyl alcohol (PVA) resin was attached by the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 95 warp yarns/inch and 95 weft yarns/inch. Here, weaving was performed so that the fabric width was 1300 mm. The weft yarn used here was a silica glass yarn having an average filament diameter of 4.0 $\mu$m, a number of filaments of 50, and a number of twists of 0.6 Z. A glass fabric of Comparative Example 4 was obtained with the glass fabric greige obtained, in the same procedure as in Example 4.

[Example 5]

A glass fabric of Example 5 was obtained in the same procedure as in Example 1 except that the glass fabric greige obtained in Example 1 was used, irradiation with ultrasound was not performed before a surface treatment, and conditions were changed as described in the Table.

[Example 6]

A glass fabric of Example 6 was obtained in the same procedure as in Example 1 except that the glass fabric greige obtained in Example 1 was used and the line speed was 80 m/min.

[Comparative Example 5]

Warp yarn warping was performed with a silica glass yarn having a compositional amount of $SiO_2$ of more than 99.9 wt% and having an average filament diameter of 6.0 $\mu$m, a number of filaments of 22, and a number of twists of 0.6 Z. The warp yarn paralleled at a conveying speed of 60 m/min was not nipped, and a sizing agent mainly containing a polyvinyl alcohol (PVA) resin was attached thereto according to the following procedure. Specifically, an aqueous solution having a concentration of PVA (trade name: PVA403, manufactured by KURARAY CO., LTD.) of 5% was produced, and 2% of hydrogenated castor oil was compounded as a lubricant to this aqueous solution, to obtain a sizing agent. The sizing agent warned at 60°C was attached to the glass yarn and then dried, thereby performing a sizing treatment. Thereafter, an air-jet loom was used to weave a fabric at a thread count of 95 warp yarns/inch and 95 weft yarns/inch. Here, weaving was performed so that the fabric width was 1300 mm. The weft yarn used here was a silica glass yarn having an average filament diameter of 6.0 $\mu$m, a number of filaments of 22, and a number of twists of 0.6 Z. A glass fabric of Comparative Example 5 was obtained in the same procedure as in Example 4 except that the glass fabric greige obtained was used and conditions were changed as described in the Table.

[Comparative Example 6]

A glass fabric of Comparative Example 6 was obtained in the same procedure as in Example 4 except that the glass fabric greige obtained in Example 4 was used and ion-exchange water at 20°C was used in the washing process before de-oiling.

[Table 1]

Table 1

| | | | Example 1 | Example 2 | Example 3 | Example 4 | Example 5 | Example 6 |
|---|---|---|---|---|---|---|---|---|
| Glass composition | $SiO_2$ | % | > 99.9 | > 99.9 | > 99.9 | > 99.9 | > 99.9 | > 99.9 |
| Warp yarn | Filament diameter ($D_{MD}$) | μm | 7.5 | 9.0 | 7.5 | 6.0 | 7.5 | 7.5 |
| | Number of filaments | filaments | 50 | 34 | 96 | 22 | 50 | 50 |
| | Weaving density | filaments/inch | 66 | 66 | 54 | 95 | 66 | 66 |
| Weft yarn | Filament diameter ($D_{TD}$) | μm | 7.5 | 9.0 | 7.5 | 6.0 | 7.5 | 7.5 |
| | Number of filaments | filaments | 50 | 34 | 96 | 22 | 50 | 50 |
| | Weaving density | filaments/inch | 68 | 68 | 54 | 95 | 68 | 68 |
| Warping Gluing condition | Nip pressure | kg/cm² | 3.0 | 3.0 | 3.5 | 3.0 | 3.0 | 3.0 |
| Washing conditions before heating/de-oiling | Solvent | - | Ion-exchange water | Ion-exchange water | Ion-exchange water | Ion-exchange water | Ion-exchange water | Ion-exchange water |
| | Temperature | °C | 60 | 60 | 60 | 60 | 60 | 60 |
| Heating/de-oiling conditions | Temperature | °C | 1000 | 1000 | 1000 | 1000 | 1000 | 1000 |
| | Heating time | - | 30 sec | 30 sec | 30 sec | 30 sec | 30 sec | 30 sec |
| Washing/filament-opening conditions | Line speed | m/min | 30 | 20 | 20 | 30 | 30 | 80 |
| | Output of ultrasound | W/cm² | 0.72 | 0.72 | 0.72 | 0.41 | - | 0.72 |
| Opening conditions after surface treatment | Spray pressure | kg/cm² | 3.0 | 3.0 | 4.0 | 2.0 | 9.0 | 3.0 |
| Physical properties of fabric | Filament diameter (D) | μm | 7.5 | 9.0 | 7.5 | 6.0 | 7.5 | 7.5 |
| | Thickness (T) | μm | 32 | 32 | 46 | 14 | 32 | 33 |
| | Warp yarn width | μm | 237 | 229 | 326 | 145 | 231 | 216 |
| | Weft yarn width | μm | 288 | 269 | 388 | 176 | 283 | 274 |
| | (Number of stacking warp yarn filaments in a bundle - 0.2)/T | /μm | 0.043 | 0.036 | 0.044 | 0.051 | 0.044 | 0.047 |

(continued)

|  |  |  | Example 1 | Example 2 | Example 3 | Example 4 | Example 5 | Example 6 |
|---|---|---|---|---|---|---|---|---|
|  | Proportion of warp yarn adhesion | - | 0.52 | 0.58 | 0.48 | 0.50 | 1.04 | 0.94 |
|  | 24D-T | μm | 148 | 184 | 134 | 130 | 148 | 147 |
|  | 14D-T | μm | 73 | 94 | 59 | 70 | 73 | 72 |
|  | Value of loss of ignition | % | 0.079 | 0.062 | 0.057 | 0.153 | 0.064 | 0.074 |
| Evaluation of fuzz | Number of pieces of fuzz | - | A | A | A | A | B | A |
| Evaluation of impregnation properties | Number of voids (after 3 minutes) | - | A | A | A | B | C | C |
| Stacked plate | Evaluation of heat resistance | - | A | A | A | B | C | C |

[Table 2]

[Table 2]

Table 2

| | | | Comparative Example 1 | Comparative Example 2 | Comparative Example 3 | Comparative Example 4 | Comparative Example 5 | Comparative Example 6 |
|---|---|---|---|---|---|---|---|---|
| Glass composition | $SiO_2$ | % | > 99.9 | > 99.9 | > 99.9 | > 99.9 | > 99.9 | > 99.9 |
| Warp yarn | Filament diameter ($D_{MD}$) | μm | 5.0 | 5.0 | 5.0 | 4.0 | 6.0 | 6.0 |
| | Number of filaments | filaments | 100 | 100 | 200 | 50 | 22 | 22 |
| | Weaving density | filaments/inch | 66 | 66 | 54 | 95 | 95 | 95 |
| Weft yarn | Filament diameter ($D_{TD}$) | μm | 5.0 | 5.0 | 5.0 | 4.0 | 6.0 | 6.0 |
| | Number of filaments | filaments | 100 | 100 | 200 | 50 | 22 | 22 |
| | Weaving density | filaments/inch | 68 | 68 | 54 | 95 | 95 | 95 |
| Warping Gluing condition | Nip pressure | kg/cm² | 3.0 | 3.0 | 3.5 | 3.0 | - | 3.0 |
| Washing conditions before heating/de-oiling | Solvent | - | Ion-exchange water | Ion-exchange water | Ion-exchange water | Ion-exchange water | Ion-exchange water | Ion-exchange water |
| | Temperature | °C | 60 | 60 | 60 | 60 | 60 | 20 |
| Heating/de-oiling conditions | Temperature | °C | 1000 | 1000 | 1000 | 1000 | 1000 | 1000 |
| | Heating time | - | 30sec | 30sec | 30sec | 30sec | 30sec | 30sec |
| Washing/filament-opening conditions | Line speed | m/min | 30 | 30 | 20 | 30 | 30 | 30 |
| | Output of ultrasound | W/cm² | 0.72 | 0.72 | 0.72 | 0.41 | 0.41 | 0.41 |
| Opening conditions after surface treatment | Spray pressure | kg/cm² | 3.0 | 9.0 | 4.0 | 2.0 | 2.0 | 2.0 |

25

(continued)

| | | | Comparative Example 1 | Comparative Example 2 | Comparative Example 3 | Comparative Example 4 | Comparative Example 5 | Comparative Example 6 |
|---|---|---|---|---|---|---|---|---|
| Physical properties of fabric | Filament diameter (D) | μm | 5.0 | 5.0 | 5.0 | 4.0 | 6.0 | 6.0 |
| | Thickness (T) | μm | 31 | 29 | 46 | 14 | 15 | 15 |
| | Warp yarn width | μm | 227 | 271 | 298 | 137 | 113 | 118 |
| | Weft yarn width | μm | 345 | 354 | 477 | 196 | 175 | 169 |
| | (Number of stacking warp yarn filaments in a bundle - 0.2)/T | /μm | 0.065 | 0.057 | 0.069 | 0.090 | 0.065 | 0.061 |
| | Proportion of warp yarn adhesion | - | 1.03 | 0.92 | 0.97 | 0.94 | 0.90 | 0.88 |
| | 24D-T | μm | 89 | 91 | 74 | 82 | 129 | 129 |
| | 14D-T | μm | 39 | 41 | 24 | 42 | 69 | 69 |
| | Value of loss of ignition | % | 0.065 | 0.062 | 0.072 | 0.160 | 0.170 | 0.170 |
| Evaluation of fuzz | Number of pieces of fuzz | - | C | D | C | D | C | C |
| Evaluation of impregnation properties | Number of voids (after 3 minutes) | - | E | D | E | E | E | E |
| Stacked plate | Evaluation of heat resistance | - | E | D | E | E | E | E |

The number of stacking warp yarn filaments in a bundle was in a predetermined range and the occurrence of fuzz was suppressed in the glass fabric of each of Examples 1 to 7, in which a glass yarn having a large filament diameter relative to the thickness of the glass fabric was used, a yarn bundle was flattened and glued during warping, and the glass fabric was washed with water at a predetermined temperature or more before heating/de-oiling. In addition, the number of stacking warp yarn filaments in a bundle and the proportion of warp yarn adhesion were in predetermined ranges and favorable resin impregnation properties and heat resistance of a stacked plate were obtained in the glass fabric of each of Examples 1 to 4, which was washed with ultrasound at a predetermined conveying speed before the surface treatment process.

The number of stacking warp yarn filaments in a bundle was increased, the occurrence of fuzz could not be suppressed, and resin impregnation properties were inferior in the glass fabric of each of Comparative Examples 1 to 4, which was produced with the filament diameter prescribed in the IPC standard. An increase in the force of processing in the filament-opening treatment caused an increase of fuzz in Comparative Example 2.

The number of stacking warp yarn filaments in a bundle and the proportion of warp yarn adhesion could not be controlled in predetermined ranges, fuzz was increased and resin impregnation properties were inferior in Comparative Example 5 in which, although a glass yarn having a large filament diameter relative to the thickness of the glass fabric was used, a yarn bundle was not flattened during warping, and Comparative Example 6 in which the process of washing the glass fabric with water at a predetermined temperature or more before heating/de-oiling was not performed.

**Claims**

1. A glass fabric constituted from a warp yarn and a weft yarn, which are a glass yarn including a plurality of filaments, wherein

   the glass yarn has a silicon (Si) content of from 95.0 wt% to 100 wt% in terms of silicon dioxide ($SiO_2$),
   the glass fabric has a thickness (T) of 80 $\mu$m or less, and
   the following formula (A1) is satisfied:

   $$\{\text{Number of stacking warp yarn filaments in a bundle (N) - 0.2}\}/\text{thickness (T) } [\mu m] < 0.056 \ ... \ (A1)$$

   in the formula (A1), the number of stacking warp yarn filaments in a bundle (N) is a value determined by Warp yarn filament diameter [$\mu$m] $\times$ Number of warp yarn filaments [filaments]/Warp yarn width [$\mu$m].

2. The glass fabric according to claim 1, wherein, when a cross section of the glass fabric is observed after the glass fabric is embedded in an epoxy resin and the epoxy resin is cured, the proportion of warp yarn adhesion calculated by the following formula is more than 0 and 0.80 or less:

   Proportion of warp yarn adhesion = Number of adhesion points of filaments adhering to each other in warp yarn/ Number of warp yarn filaments.

3. The glass fabric according to claim 1, wherein the glass fabric is treated with a surface treatment agent containing a silane coupling agent.

4. The glass fabric according to claim 3, wherein the silane coupling agent contains a compound represented by the following formula (C):

   $$X(R)_{3-n}SiY_n \ ... \qquad (C)$$

   in the formula (C), X is an organic group having at least one of an amino group and an unsaturated double bond group having radical reactivity, Y is each independently an alkoxy group, n is an integer of 1 or more and 3 or less, and R is each independently a group consisting of a methyl group, an ethyl group, and a phenyl group.

5. The glass fabric according to claim 4, wherein X in the formula (C) is an organic group having one or more methacryloyloxy groups or acryloyloxy groups.

6. The glass fabric according to any one of claims 1 to 5, wherein the glass yarn has an average filament diameter (D) of 4 $\mu$m or more.

7. The glass fabric according to any one of claims 1 to 6, wherein the following formula (B1) is satisfied when the thickness of the glass fabric is 20 $\mu$m or more and 80 $\mu$m or less, and the following formula (B6) is satisfied when the thickness of the glass fabric is less than 20 $\mu$m.

$$24 \times \text{average filament diameter (D) } [\mu m] - \text{thickness (T) } [\mu m] > 96 \,... \text{ (B1)}$$

$$14 \times \text{average filament diameter (D) } [\mu m] - \text{thickness (T) } [\mu m] > 46 \,... \text{ (B6)}$$

8. The glass fabric according to any one of claims 1 to 5, wherein the thickness (T) of the glass fabric is 60 $\mu$m or less.

9. The glass fabric according to any one of claims 1 to 5, wherein the glass fabric has a value of loss of ignition in a range of 0.01 wt% to 0.30 wt%.

10. The glass fabric according to any one of claims 1 to 5, for a printed circuit board.

11. A prepreg containing the glass fabric according to any one of claims 1 to 5, a thermosetting resin, and an inorganic filler.

12. A printed circuit board comprising the prepreg according to claim 11.

13. An integrated circuit comprising the printed circuit board according to claim 12.

14. An electronic device comprising the printed circuit board according to claim 12.

15. A method for producing a glass fabric, the method comprising:

weaving a glass yarn, which includes a plurality of filaments and has a Si content in a range of 95.0 wt% to 100 wt% in terms of $SiO_2$, as each of a warp yarn and a weft yarn, to obtain a glass fabric; and
wherein the method further comprises a warping process of flattening and then sizing a yarn bundle of the glass yarn before the weaving process; and
wherein the method further comprises, after the warping process and before, during or after the weaving process, the following:

washing the glass yarn with water at 50°C or more;
heating/de-oiling the glass yarn washed; and
washing and filament-opening the heated/de-oiled glass yarn, with conveying the glass yarn at a rate of 50 m/min or less in a liquid being irradiated with ultrasound;

wherein the glass fabric after the filament-opening treatment has a thickness (T) of 80 $\mu$m or less, and the following formula (B 1) is satisfied when the thickness of the glass fabric after the filament-opening treatment is 20 $\mu$m or more and 80 $\mu$m or less, and the following formula (B6) is satisfied when the thickness of the glass fabric after the filament-opening treatment is less than 20 $\mu$m.

$$24 \times \text{average filament diameter (D) } [\mu m] - \text{thickness (T) } [\mu m] > 96 \,... \text{ (B1)}$$

$$14 \times \text{average filament diameter (D) } [\mu m] - \text{thickness (T) } [\mu m] > 46 \,... \text{ (B6)}$$

16. The method according to claim 15, further comprising subjecting the washed and filament-opened glass fabric to a surface treatment with a surface treatment agent.

# Fig. 1

(a)

(b)

SU3500 15.0kV 6.3mm x2.00k BSE-3D 30Pa          20.0μm

## INTERNATIONAL SEARCH REPORT

| International application No. |
|---|
| **PCT/JP2023/044188** |

### A. CLASSIFICATION OF SUBJECT MATTER

*D03D 15/267*(2021.01)i; *C08J 5/24*(2006.01)i; *D03D 1/00*(2006.01)i; *D06B 13/00*(2006.01)i; *D06M 13/507*(2006.01)i; *H05K 1/03*(2006.01)i

FI: D03D15/267; D03D1/00 Z; D06M13/507; D06B13/00; C08J5/24; H05K1/03 610T

According to International Patent Classification (IPC) or to both national classification and IPC

### B. FIELDS SEARCHED

Minimum documentation searched (classification system followed by classification symbols)

D03D1/00-27/18; C08J5/00-5/02;5/12-5/22;
D06B1/00-23/30;D06C3/00-29/00@Z;D06G1/00-5/00;D06H1/00-7/24;D06J1/00-1/12;D06M13/00-15/715; H05K1/00-1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2002-339191 A (ASAHI SCHWEBEL CO., LTD.) 27 November 2002 (2002-11-27) claim 1, example 5, table 1, paragraphs [0015], [0017], [0019] | 1-6, 8-14 |
| A | entire text | 7, 15-16 |
| A | JP 2002-242047 A (ASAHI SCHWEBEL CO., LTD.) 28 August 2002 (2002-08-28) paragraph [0024] | 1 |
| Y | JP 2018-127747 A (ASAHI KASEI KABUSHIKI KAISHA) 16 August 2018 (2018-08-16) example 2, paragraphs [0016], [0025]-[0026], [0030] | 1-6, 8-14 |
| A | JP 2020-158387 A (NITTO BOSEKI CO., LTD.) 01 October 2020 (2020-10-01) paragraph [0078] | 6 |
| Y | JP 2001-73249 A (UNITIKA GLASS FIBER CO., LTD.) 21 March 2001 (2001-03-21) claims 1, 4, example 1, paragraph [0016] | 1-6, 8-14 |
| A | entire text | 7, 15-16 |

☐ Further documents are listed in the continuation of Box C.　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 January 2024** | **20 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

INTERNATIONAL SEARCH REPORT
Information on patent family members

International application No.

**PCT/JP2023/044188**

| Patent document cited in search report | | | Publication date (day/month/year) | Patent family member(s) | Publication date (day/month/year) |
|---|---|---|---|---|---|
| JP | 2002-339191 | A | 27 November 2002 | (Family: none) | |
| JP | 2002-242047 | A | 28 August 2002 | (Family: none) | |
| JP | 2018-127747 | A | 16 August 2018 | US 2018/0305846 A1<br>examples 1-2, paragraphs<br>[0133], [0172]-[0173], [0178]<br>CN 108411446 A<br>CN 113235204 A<br>CN 113337934 A | |
| JP | 2020-158387 | A | 01 October 2020 | US 2022/0106453 A1<br>paragraph [0081]<br>WO 2020/194772 A1<br>KR 10-2021-0121121 A<br>CN 113631525 A<br>TW 202035327 A<br>SG 11202108787V A | |
| JP | 2001-73249 | A | 21 March 2001 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023023729 A
- JP 2018127747 A
- JP 2018127752 A
- JP 2015078079 A

- JP 2009263824 A
- JP 2020158945 A
- JP 2022181738 A
- JP 2003082562 A